(19) **Europäisches Patentamt**

**European Patent Office**

**Office européen des brevets**

(11) **EP 1 331 734 A2**

(12) **EUROPÄISCHE PATENTANMELDUNG**

(43) Veröffentlichungstag:
**30.07.2003 Patentblatt 2003/31**

(51) Int Cl.⁷: **H03H 21/00**

(21) Anmeldenummer: **03001775.0**

(22) Anmeldetag: **28.01.2003**

(84) Benannte Vertragsstaaten:
**AT BE BG CH CY CZ DE DK EE ES FI FR GB GR HU IE IT LI LU MC NL PT SE SI SK TR**
Benannte Erstreckungsstaaten:
**AL LT LV MK RO**

(30) Priorität: **29.01.2002 AT 1342002**

(71) Anmelder: **Siemens Aktiengesellschaft**
**80333 München (DE)**

(72) Erfinder: **Die Erfindernennung liegt noch nicht vor**

(74) Vertreter: **Berg, Peter, Dipl.-Ing. et al**
**European Patent Attorney,**
**Siemens AG,**
**Postfach 22 16 34**
**80506 München (DE)**

(54) **Verfahren zur Koeffizientenadaption bei einem digitalen Filter nach dem Equation-Error-Prinzip**

(57) Es wird ein Verfahren zur Koeffizientenadapton bei einem digitalen Filter nach dem Equation-Error-Prinzip angegeben, bei dem mittels skaliertem Fehlervektor eine skalierte Fehlersumme bestimmt wird und diese Fehlersumme rekursiv minimiert wird.

Fig. 1

**Beschreibung**

Die Erfindung betrifft ein Verfahren zur Koeffizientenadaption bei einem digitalen Filter nach dem Equation-Error-Prinzip.

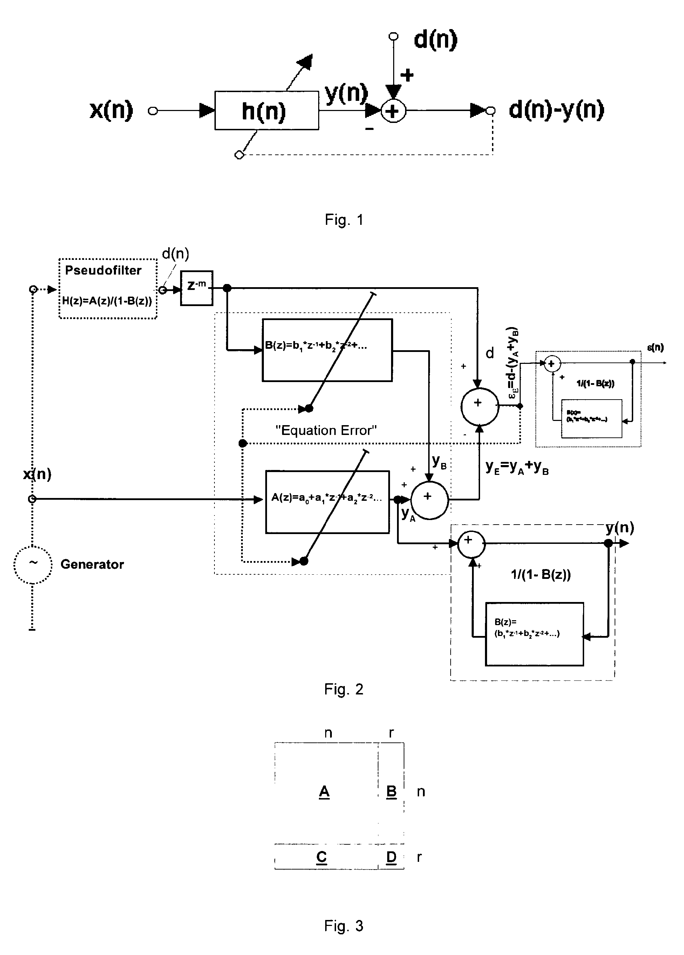

Die digitale Signalverarbeitung befaßt sich u.a. mit dem sogenannten Optimal-Filter-Problem. Dieses besteht darin, die - zu einer Eingangsfolge x(n) gehörige - Ausgangsfolge eines linearen zeitinvarianten Filters y(n) ("Schätzfolge"), durch Adaption der Filterparameter, möglichst gut einer Referenzfolge d(n) ("desired sequence") anzupassen (Fig.1).

Für gewöhnlich werden dabei nur Filter des Typs "FIR (Finite Impulse Response)" der Länge P verwendet, deren Koeffizienten adaptiert werden, somit die Ausgangsfolge y(n) nur als Linearkombination der Glieder der Eingangsfolge x(n), nach Gleichung G.1,

$$y(n) = \sum_{k=0}^{P-1} h(k) \cdot x(n-k)$$

G.1

gebildet. Mit $h(k) \equiv a_k$, $k := 0,1..P - 1$, kann dieses Verhalten auch in Form der Systemfunktion $H(z)=A(z)=a_0 + a_1 \cdot z^{-1} + ... + a_{P-1} \cdot z^{-(P-1)}$, dargestellt werden. Da diese FIR-Filter keine Rückkopplungsstrukturen vom Ausgangsignal y(n) her aufweisen, treten keine Probleme bezüglich Stabilität bzw. Fehlerflächen auf, welche hingegen, im allgemeinen Fall der Synthese sogenannter IIR (Infinite Impulse Response) -Filter, mit der Systemfunktion

$$H(z) = \frac{A(z)}{1 - B(z)} = \frac{a_0 + a_1 \cdot z^{-1} + ... + a_{P-1} \cdot z^{-(P-1)}}{1 - \left[ b_1 \cdot z^{-1} + b_2 \cdot z^{-2} + ... + b_{P_r-1} \cdot z^{-(P_r-1)} \right]},$$

G.2

wegen der Rückkopplungspfade, vielfach unüberwindlich sind. Praktisch wird daher meist nur mittels des sogenannten Least Mean Squares (LMS)-Algorithmus der Koeffizientensatz eines FIR-Filters schrittweise ermittelt. Es sind zwar direkte Methoden für den allgemeineren Fall der IIR-Struktur gemäß Gleichung G.2 bekannt, doch wird auch bei diesen fast ausschließlich der LMS-Algorithmus verwendet und angestrebt, instabiles Verhalten durch nachträgliche Kontrolle des gefundenen Koeffizientensatzes zu vermeiden. Wegen dieser Einschränkungen haben diese Verfahren kaum praktische Verbreitung gefunden. Zudem tritt eine erhebliche Lernzeit bei der Adaption ein.

Oft bieten Methoden, welche durch Adaption von Parametern, die nicht nur Nullstellen, sondern auch Pole der Systemfunktion bestimmen, die einzige Möglichkeit manche praktischen Aufgaben befriedigend zu lösen. Aus Widrow, B., Stearns, S. "Adaptive Signal Processing", Prentice- Hall, Englewood Cliffs, New Jersey 1985, ist eine angenäherte IIR-Filter Synthese nach der sogenannten "Equation Error Methode" bekannt, wobei zur Adapiton ebenfalls der LMS-Algorithmus (mit langer Lernzeit) verwendet wird. Wie dort erläutert, liefert dieses Verfahren nicht genau das Minimum des Erwartungswerts des Fehlerquadrates eines konventionellen adaptiven IIR-Filters. Praktisch erzeugt aber die Adaption der A(z) und B(z) nach Gleichung G.2 im Sinne der kleinsten Summe der Fehlerquadrate des "Equation Errors", jedoch sehr ähnliche Ergebnisse , jedoch ohne die Stabilitätsprobleme eines direkt synthetisierten (falls überhaupt möglich) IIR-Filters.

Aus der DE197 02 321 ist weiterhin für den Typ "FIR-Filter" die Vorstellung bekannt, daß über der Eingangsfolge $x(0),x(1)..x(N_s - 1)$, bzw. Referenzfolge $d(0),d(1)..d(N_s - 1)$, ein Fenster gleitet, welches zum Zeitpunkt n (P - $1\_n\_N_s$ - K) gerade aus der Eingangsfolge den Ausschnitt $x(n - P + 1)..x(n - 1),x(n),x(n + 1)..x(n - k)..x(n + K - 1)$, bzw. aus der Referenzfolge den Ausschnitt $d(n),d(n + 1)..d(n + K - 1)$, zu sehen gestattet. Für die, in diesem aktuellen Ausschnitt sichtbaren, Werte können die Elemente des optimalen Koeffizientenvektors $\mathbf{h}_{opt}(n)$ ermittelt werden. Beim Weitergleiten des Fensters vom Bezugspunkt n nach n+1- um nun $\mathbf{h}_{opt}(n + 1)$ zu ermitteln -wäre sofort wieder die gesamte Berechnung zu erbringen, obwohl nur die Werte x(n+K) und d(n+K) neu hinzu kommen und x(n-P+1) und d(n) wegfallen.

Eine rekursive Ermittlung von $\mathbf{h}_{opt}(n + 1)$ aus $\mathbf{h}_{opt}(n)$ erscheint daher wünschenswert und ist wegen der wenigen, sich beim Übergang von n zu n+1 ändernden Daten, mittels des in DE197 02 321 beschriebenen Algorithmus möglich.

Der Erfindung liegt die Aufgabe zugrunde, ein Verfahren zur sehr gut angenäherten Ermittlung des Koeffizientensatzes eines IIR-Filters mit der Systemfunktion (G.2) bei kürzestmöglicher Lernzeit anzugeben.

Erfindungsgemäß erfolgt dies mit einem Verfahren gemäß Anspruch 1, eine vorteilhafte Ausgestaltung der Erfindung ist in Anspruch 2 beschrieben.

Die Erfindung wird anhand von drei Figuren näher erläutert. Es zeigen beispielhaft

Fig.1 eine Darstellung des Optimal Filter-Problems
Fig.2 die logische Struktur des erfindungsgemäßen Verfahrens
Fig.3 zulässige Matrizenformate für Gleichung G.35

Im Folgenden wird anhand der Fig.1 das Optimal Filter-Problem näher beschrieben. Dabei wird von vorgegebenen Datenfolgen ausgegangen, nicht von Zufallsprozessen. Somit sind die Datenfolgen $x(0),x(1)..x(N_s - 1)$ und $d(0),d(1)..d(N_s - 1)$ gegeben; im Fall, daß ein kausales FIR-Filter der Länge P verwendet wird, erhält man für die auf Basis von $x(n)$ und $d(n)$ als Schätzung von $d(n)$ ermittelte Folge $y(n)$ nach G.1. Der Fehler kann durch

$$\varepsilon(n) = d(n) - y(n) \qquad\qquad\text{G.3}$$

definiert werden. Das Ziel ist, den "besten Einheitsimpuls-Antwortsvektor" $\mathbf{h}_{opt}(n)$, zu finden.
Dieser wird gewöhnlich so definiert, daß die Wahl von $\mathbf{h}_{opt}=\mathbf{h}_{opt}(n)$ sicherstellt, daß die Summe der Fehlerquadrate minimal wird, also:

$$S = \sum_{t=n}^{n+K-1} (|\varepsilon(t)|)^2 = \text{Min } n\_P-1 \qquad n\_N_s - K \qquad\qquad\text{G.4}$$

Erfindungsgemäß ist es zweckmäßiger gewichtete Fehlergleichungen

$$\kappa(n)\cdot\varepsilon(n) = \kappa(n)\cdot d(n) - \kappa(n)\cdot y(n), \qquad\qquad\text{G.5}$$

zu benutzen. Gleichung G.1 kann auch als Matrizengleichung beschrieben werden:

$$y:=\underline{x}\cdot h \qquad\qquad\text{G.6}$$

$$\mathbf{y}(n)=\begin{bmatrix} y(n) \\ y(n+1) \\ .. \\ y(n+k) \\ .... \\ y(n-K+1) \end{bmatrix} \qquad\qquad\text{G.7}$$

wobei

$$\underline{X}(n) := \begin{bmatrix} x(n) & x(n-1) & \ldots & x(n-P+1) \\ x(n+1) & x(n) & \ldots & x(n-P+2) \\ \ldots & \ldots & \ldots & \ldots \\ x(n+k) & x(n+k-1) & \ldots & x(n+k-P+1) \\ \ldots & \ldots & \ldots & \ldots \\ x(n+K-1) & x(n+K-2) & \ldots & x(n+K-P) \end{bmatrix}$$

G.8

und

$$\mathbf{h}(n) = \begin{bmatrix} h(0) \\ h(1) \\ \ldots \\ h(\ell) \\ \ldots \\ h(P-1) \end{bmatrix}$$

G.9

ist. In der gesamten Beschreibung werden Vektoren durch Fettdruck, Matrizen mit unterstrichenem Fettdruck gekennzeichnet. Eine einfache Generalisierung der Betrachtungen wurde durch Berücksichtigung komplexer Datenvektoren vorgenommen. Somit besitzt ein komplexer Vektor x die Komponenten $x_k = x_{rk} + j \cdot x_{ik}$, wobei er durch $\mathbf{x} := \mathbf{x_r} + j \cdot \mathbf{x_i}$ definiert ist. Die Matrix $\underline{x}$ wird als Datenmatrix bezeichnet (Dimension: K*P, K>P). Vielfach wird $\underline{x}$ "lang und schmal" sein, da K >> P sein kann.

Zur Skalierung nach Gleichung G.5 wird die Diagonalmatrix

$$\underline{K}(n) := \begin{bmatrix} \kappa(n) & 0 & \ldots & 0 \\ 0 & \kappa(n+1) & \ldots & 0 \\ \ldots & \ldots & \ldots & \ldots \\ 0 & 0 & \ldots & 0 \\ \ldots & \ldots & \ldots & \ldots \\ 0 & 0 & \ldots & \kappa(n+K-1) \end{bmatrix}$$

G.10

definiert, womit an Stelle von Gleichung G.6

$$\underline{K} \cdot \mathbf{y} := \underline{K} \cdot \underline{X} \cdot \mathbf{h}$$

G.11

tritt. Betrachtet man **d** und ε als K-dimensionale Vektoren, deren Komponenten analog zu Gleichung G.7 aus den Folgen d(n) und ε(n) ermittelt werden, dann kann wegen der Beziehung gemäß Gleichung G.5 das Produkt von Gleichung G.10 mit dem Fehlervektor ε und schließlich die (skalierte) Summe

$$S_s := (\overline{(\underline{K} \cdot \varepsilon)})^T \cdot (\underline{K} \cdot \varepsilon)$$

G.12

gebildet werden. Entsprechend Gleichung G.4 wird das Minimum dieser Summe gesucht. Eine notwendige Bedingung für ein Minimum von Gleichung G.12 findet man durch Differentiation, also

$$\text{grad } S_s(h) = 0 \qquad\qquad\qquad\qquad\qquad \text{G.13}$$

und somit als Lösung G.14 von Gleichung G.13 -falls alle Skalenfaktoren gleich Eins sind, in Form der bekannten, sogenannten "Wiener-Hopf"-Gleichung, allgemeiner - mit Gleichung G.10

$$\underline{R}_s := (\underline{\overline{X}})^T \cdot (\underline{\overline{K}})^T \cdot \underline{K}\ \underline{X} \qquad\qquad P_s := (\underline{\overline{X}})^T \cdot (\underline{\overline{K}})^T \cdot \underline{K} \cdot d \qquad\qquad \text{G.14a}$$

$$\underline{R}_s \cdot h = P_s \qquad\qquad\qquad\qquad \text{G.14b}$$

$\underline{R}_s$ ist eine, gemäß Gleichung G.10 skalierte, (unnormalisierte) Korrelationsmatrix, $\mathbf{P}_s$ ein, gemäß Gleichung G.10 skalierter, Kreuzkorrelationsvektor. Wenn $\underline{KX}$ unabhängige Zeilen hat, dann ist auch $\underline{R}_s$ von vollem Rang und aus Gleichung G.14 folgt dann der optimale Koeffizientenvektor

$$h = h_{opt} = \underline{R}_s^{-1} \cdot P_s = ((\underline{\overline{X}})^T \cdot (\underline{\overline{K}})^T \cdot \underline{K}\ \underline{X})^{-1} \cdot ((\underline{\overline{X}})^T \cdot (\underline{\overline{K}})^T \cdot K \cdot d)^{-1} \qquad\qquad \text{G.15}$$

Vorteilhaft ist es, wenn aus einem zum Zeitpunkt n bekannten optimalen Koeffizientensatz des digitalen Filters ein für den Zeitpunkt n+1 optimaler Koeffizientensatz rekursiv mittelt werden kann. Für den Spezialfall eines FIR-Filters, bei dem alle Skalenfaktoren gleich Eins sind, erfüllt diese Forderung der in DE197 02 321 beschriebene rekursive Algorithmus.

Die vorliegende Erfindung erweitert die Synthese eines FIR-Filters zu einer allgemeineren IIR-Filtersynthese, jedoch dies nicht in konventioneller Weise, sondern unter Benutzung der "Equation Error"-Methode. Dies ermöglicht es, statt der Datenmatrix $\underline{X}$ nach Gleichung G.8 -

zu einer durch zusätzliche Spalten erweiterten - Matrix - $\underline{X}_E$ überzugehen, und diese formal an Stelle von Datenmatrix $\underline{X}$ in der "Wiener-Hopf" Gleichung G.14 zu benutzen. Diese Vorgehensweise bewirkt letztendlich eine deutliche Vereinfachung und damit Beschleunigung des Berechnungsaufwandes und ermöglicht damit die praktische Anwendung des Verfahrens auch für zeitkritische Echtzeitanwendungen.

Zunächst einige Anmerkungen zur "Equation Error"-Methode:

Adaptive Filter können zum Modellieren, also zur Imitation des dynamischen Verhaltens physikalischer Systeme (unbekannte "Black Boxes") benutzt werden. Bei direkter Modellierung eines dynamischen Systems - also der Strecke ("Plant") im Sinne der Regelungstechnik - mit je einem Ein-und Ausgang, wird sowohl der Eingang des unbekannten Systems als auch der Eingang des adaptiven Filters vom selben Eingangssignal ausgesteuert. Für das adaptive Filter besteht die Aufgabe darin, sein Ausgangssignal jenem des unbekannten Systems im Sinne der kleinste Fehlerquadrate anzupassen. Besitzt das adaptive Filter ausreichende Freiheitsgrade (Koeffizienten), so ist eine gute Anpassung an das Ausgangssignal der Black Box möglich; somit kann das adaptive Filter als Modell des unbekannten Systems betrachtet werden ("System Identification"). Gewöhnlich wird in diesem Zusammenhang die Synthese eines FIR-Digitalfilters behandelt, dessen vorgegebene Einheitsimpulsantwort optimal (nach Adaption) durch jene eines adaptiven Filters angenähert ist. Dabei dient als Realisierungskonzept für die Spezifikation eine Black Box in Form eines "Pseudofilters", welches im allgemeinen nicht physikalisch existieren muß; N Sinusschwingungsgeneratoren, bilden der Spezifikation entsprechend in Summe das Eingangssignal für das Pseudo- und das adaptive Filter. Das Ausgangssignal des Pseudofilters entspricht dem Referenzsignal ("desired response"). Die Differenz zwischen diesem und dem des adaptiven Filters stellt das Fehlersignal dar. Mit Hilfe der "Wiener-Hopf" Gleichung G.14 kann der optimale Koeffizientenvektor gefunden werden.

Diesem direkten Modellieren ("direct modeling") steht ein anderes Verfahren, das sogenannte inverse Modellieren ("inverse modeling") gegenüber. Das inverse Modell eines Systems hat eine Übertragungsfunktion, die in bestimmter Weise optimal an die inverse Übertragungsfunktion der unbekannten Systemfunktion angepaßt ist. Bildet das Ausgangssignal des unbekannten Systems ("Pseudofilters") das Eingangssignal für das adaptive Filter, so kann die optimale Anpassung des Ausgangssignales des adaptiven Filters an das Eingangssignal des "Pseudofilters" im Sinne der kleinsten Fehlerquadrate verlangt werden. Ist das unbekannte System kausal, so müßte das adaptive Filter eine Prädiktion leisten. Vielfach kann jedoch eine verzögerte inverse Übertragungsfunktion akzeptiert werden, so daß die Prädiktionsanforderung an das adaptive Filter entfällt.

"Direct modeling" und "inverse modeling" sind z.B. ausführlich in Widrow, B., Stearns,S. "Adaptive Signal Processing", Prentice- Hall, Englewood Cliffs, New Jersey 1985 behandelt. Besonders "Inverse modeling" hat hier deshalb Bedeutung, weil damit bekannte Probleme konventioneller adaptiver IIR-Filter, bezüglich der Fehlerflächen und Stabilität, umgangen werden können. Bei dem erfindungsgemäß verwendeten Verfahren (Fig. 2) wird simultan "direct modeling" zur Synthese des Vorwärtspfades - des nichtrekursiven Teils - des IIR-Filters und "inverse modeling" zur Synthese des Rückkopplungspfades der Systemfunktion (G.2) benutzt. Zur Adaption des Filters im Sinne einer besten Anpassung an das "Pseudofilter" stehen also P Koeffizienten und $P_r$ - 1 ($P_r$ - 1≥1) Koeffizienten des Feedback-Pfades zur Verfügung. Wie im zitierten Werk erläutert, liefert dieses Verfahren des "simultaneous direct and inverse modeling" oder "equation error modeling" nicht genau das Minimum des Erwartungswerts des Fehlerquadrates eines konventionellen adaptiven IIR-Filters. Praktisch erzeugt aber die Adaption der Teilblöcke A(z) und B(z), im Sinne der kleinsten Summe der Fehlerquadrate des "Equation Errors", sehr ähnliche Ergebnisse in einem mit diesen Teilblöcken gebildeten IIR-Filter. Dieses besteht aus der Kettenschaltung des bestehenden Vorwärtspfades A(z) mit einer Rückkopplungsschleife, die B(z) - wie in Fig. 2 rechts unten angedeutet - durch Kopie der Koeffizienten berücksichtigt und die dann das Ausgangssignal des IIR-Filters liefert. Der Verzögerungsblock mit (mit möglichst gering gewählter Verzögerung) $z^{-m}$, sichert minimale Phase für 1-B(z).

Das, durch die Idee des "simultaneous direct and inverse modeling" geprägte, Verfahren nach Widrow, B., Stearns, S. "Adaptive Signal Processing", kann strukturell so umgeformt werden, daß die Verbindung zum Optimal-Filter-Problem nach Fig. 1 deutlich wird. Die so gefundene Struktur nach Fig. 2 wird beim erfindungsgemäß verallgemeinerten Verfahren benutzt, dabei wird aber, wie später ausgeführt, rekursiv und mit kürzestmöglicher Lernzeit adaptiert.

Wie oben erwähnt, liefert das "equation error modeling" nicht genau das Minimum des Erwartungswertes des Fehlerquadrates eines konventionellen adaptiven IIR-Filters. Dies bedeutet, daß die (vorgegebene) Systemfunktion des "Pseudofilters" durch die Systemfunktion des digitalen Filters nach erfolgter Adaption zwar praktisch, jedoch nicht theoretisch genau modelliert wird. Diese geringe Abweichung zwischen den beiden Systemfunktionen, auch nach erfolgter Adaption, bedingt, daß für deren Koeffizienten $h_A(k) \approx a_k$, k := 0, 1..P - 1 und $h_B(k) \approx b_k$, k := 0, 1.. $P_r$ - 1 gilt. Beim digitalen Filter wird dieser Unterschied bezüglich der Bezeichnung der Elemente des Koeffizientenvektors, die A(z) des Pseudofilters modellieren, statt mit $a_0, a_1,...,a_{P-1}$, korrekt mit $h_A(0), h_A(1),...,h_A(P - 1)$ berücksichtigt und bei jenen, die B(z) modellieren, statt mit $b_1, b_2,...,b_{P_r-1}$ mit $h_B(1), h_B(2),...,h_B(P_r - 1)$; $P_r$ - 1≥1. Um die Übersichtlichkeit nicht zu gefährden, wird hingegen in Fig. 2, - die nur praktisch gültige - Vereinfachung der kürzeren Schreibweise $h_A(k) = a_k$, $h_B(k) = b_k$, benutzt.

Gleichung G.1 entspricht somit (vergl. Fig. 2)

$$y_A = \sum_{k=0}^{P-1} h_A(k) \cdot x(n-k) \qquad \text{G.16}$$

Offensichtlich ist, daß - falls $P_r$ - 1≥1.

$$y_B = \sum_{k=1}^{P_r-1} h_B(k) \cdot d(n-k) \qquad \text{G.17}$$

gilt. Mit

$$y_E = y_A + y_B, \qquad \text{G.18}$$

folgt für den "Equation Error"

$$\varepsilon_E(n) = d(n) - y_E = d(n) - (y_A + y_B). \qquad \text{G.19}$$

Das Ziel ist wie früher den "besten Einheitsimpuls - Antwortsvektor" $\mathbf{h}_{Eopt}(n)$ zu finden.

Dieser ist so definiert, daß durch die Wahl von $\mathbf{h}(n) = \mathbf{h}_{Eopt}(n)$, die Summe der Fehlerquadrate minimal wird,

also:

$$S_E = \left[ \sum_{t=n}^{n+K-1} \left( \left| \varepsilon_E(t) \right| \right)^2 = Min \right] \qquad n \geq P-1 \qquad\qquad n \leq N_s - K \qquad . \qquad\qquad G.20$$

Bei dieser Methode der kleinsten Quadrate läuft das Filter vom Startpunkt t=n bis zum Endpunkt t=n+K-1. In Analogie zu Gleichung G.5 werden gewichtete Fehlergleichungen

$$\kappa(n) \cdot \varepsilon_E(n) = \kappa(n) \cdot d(n) - \kappa(n) \cdot y_E \qquad\qquad G.21$$

benutzt. Ausgehend von den Gleichungen G.16 bis G.18 kann geschrieben werden:

$$y_E = \underline{x}_E \cdot \underline{h}_E \qquad\qquad G.22$$

mit

$$\mathbf{y}_E(n) = \begin{bmatrix} y_E(n) \\ y_E(n+1) \\ .. \\ y_E(n+k) \\ .... \\ y_E(n-K+1) \end{bmatrix} = \begin{bmatrix} y_A(n) \\ y_A(n+1) \\ .. \\ y_A(n+k) \\ .... \\ y_A(n-K+1) \end{bmatrix} + \begin{bmatrix} y_B(n) \\ y_B(n+1) \\ .. \\ y_B(n+k) \\ .... \\ y_B(n-K+1) \end{bmatrix} , \qquad G.23$$

wobei $(P_r - 1 \geq 1)$

$$\underline{X}_E(n) := \begin{bmatrix} x(n) & x(n-1) & ... & x(n-P+1) & d(n-1) & ... & d(n-P_r+1) \\ x(n+1) & x(n) & ... & x(n-P+2) & d(n) & ... & d(n-P_r+2) \\ ... & ... & ... & ... & ... & ... & ... \\ x(n+k) & x(n+k-1) & ... & x(n+k-P+1) & d(n+k-1) & ... & d(n+k-P_r+1) \\ ... & ... & ... & ... & ... & ... & ... \\ x(n+K-1) & x(n+K-2) & ... & x(n+K-P) & d(n+K-2) & ... & d(n+K-P_r) \end{bmatrix} \quad G.24$$

und

$$\mathbf{h}_E(n) = \begin{bmatrix} h_A(0) \\ h_A(1) \\ \dots \\ h_A(P-1) \\ h_B(1) \\ \dots \\ h_B(P_r-1) \end{bmatrix}_n \qquad\qquad \text{G.25}$$

ist.

Zur erfindungsgemäßen Skalierung nach Gleichung G.21 wird die Diagonalmatrix K(n) nach G.10 verwendet, was statt G.22

$$\underline{K} \cdot \underline{y}_E := \underline{K} \cdot \underline{X}_E \cdot \underline{h}_E \qquad\qquad \text{G.26}$$

ergibt. Betrachtet man in Analogie zu Gleichung G.3 $\mathbf{d}$ und $\varepsilon_E$ als K-dimensionale Vektoren, deren Komponenten analog zu G.22 aus den Folgen d(n) und $\varepsilon_E(n)$ stammen, dann kann wegen G.21 das Produkt von G.10 mit dem Fehlervektor $\varepsilon_E$ und schließlich die skalierte Summe

$$S_{s_E} := (\overline{(\underline{K} \cdot \varepsilon_E)})^T \cdot (\underline{K} \cdot \varepsilon_E) \qquad\qquad \text{G.27}$$

gebildet werden. Entsprechend G.20 wird das Minimum dieser Summe gesucht. Wegen der Analogie zwischen den Gleichungen G.12 und G.24 wird formal durch sinngemäßes Hinzufügen von E ("Equation Error"-Methode) als Index der Gleichungen die "Wiener-Hopfgleichung" - jetzt aber als (faktisch andere) Bedingung für die minimale Summe des "Equation Error" in Fig. 2 - erhalten:

$$\underline{R}_{sE} \cdot \underline{h}_E = P_{sE} \qquad\qquad \text{G.28a}$$

mit

$$\underline{R}_{sE} := (\overline{\underline{X}_E})^T \cdot (\overline{\underline{K}})^T \cdot \underline{K X}_E \qquad P_{sE} := \underline{X}_E^{\ T} \cdot (\overline{\underline{K}})^T \cdot \underline{K} \cdot \mathbf{d} \qquad\qquad \text{G.28b}$$

Der im Sinne der "Equation Error"-Methode optimale Koeffizientenvektor ist, mit $\underline{x}_E$ nach G.24,

$$\underline{h}_E = \underline{h}_{Eopt} = \underline{R}_{sE}^{-1} \cdot P_{sE} = \left( (\overline{\underline{X}_E})^T \cdot (\overline{\underline{K}})^T \cdot \underline{K} \ \underline{X}_E \right)^{-1} ((\overline{\underline{X}}_E)^T \cdot (\overline{\underline{K}})^T \cdot \underline{K} \cdot \mathbf{d})^{-1} \qquad\qquad \text{G.29}$$

Somit wurde mit der erfindungsgemäßen Idee von der Synthese eines FIRFilters, zur allgemeineren IIR-Filtersynthese, jedoch dies nicht in konventioneller Weise, sondern unter Benutzung der "Equation Error"-Methode überzugehen, erreicht, daß statt der Datenmatrix $\underline{x}$ nach Gleichung G.8, die durch zusätzliche Spalten erweiterte Matrix $\underline{x}_E$ nach Gleichung G.24, formal an Stelle von $\underline{x}$ in der "Wiener-Hopf" Gleichung aufscheint und so deren - wegen des hohen Rechenaufwandes bei der Inversenbildung, nur theoretisch interessante - Lösung G.29 zu finden.

Besonders nützlich ist für das praktische Verfahren, daß dieser Kunstgriff formal auch im gleitenden Datenfenster Vorteile bringt. Nach dem erfindungsgemäßen Verfahren ist es nämlich möglich - auch bei beliebig großer Koeffizientenanzahl - durch rekursive Berechnung mit der Inversen einer 2*2-Matrix auszukommen:

Um nämlich zu erreichen, daß die über n, n+1,..., N+K-1 erstreckte Summe der Quadrate skalierter Fehler nach Gleichung G.21 durch optimale Wahl der Elemente des Vektors $\mathbf{h}_E(n) = (h_A(0)\ h_A(1)\ ....\ h_A(P-1)\ h_B(1)\ ....\ h_B(P_r-1))^T$

minimisiert - somit $h_A(k) \approx a_k$, $h_B(k) \approx bk$ nach $K + P + P_r$ -Abtastwerten erreicht- wird, genügt es bei Anwendung des erfindungsgemäßen Verfahrens, daß ausgehend von einem, zum Zeitpunkt n bekannten, optimalen Koeffizientensatz $\mathbf{h}_E(n)$, bekannter Inverser $\underline{R}_{sE}^{-1}$ und $\mathbf{P}_{sE}$, für den Zeitpunkt n+1, die Lösung $\mathbf{h}_E(n+1)$ der 'Wiener-Hopf'- Gleichung $\underline{R}_{sE} \cdot \mathbf{h}_E = \mathbf{P}_{sE}$ G.28a so rekursiv zu ermitteln, daß stets nur eine 2x2-Matrix

$$\underline{S}_E := \begin{pmatrix} \dfrac{1}{\kappa(n)^2} & 0 \\ 0 & \dfrac{1}{\kappa(n+K)^2} \end{pmatrix} - \underline{C}_E \cdot \underline{R}_{sE}^{-1} \cdot \underline{C}_E^T \cdot \begin{pmatrix} 1 & 0 \\ 0 & -1 \end{pmatrix} \qquad \text{G.30}$$

im Verlauf der rekursiven Berechnung invertiert werden muß, wobei eine Informationsmatrix

$$\underline{C}_E = \begin{bmatrix} \mathbf{x}_E^n \\ \mathbf{x}_E^{n+K} \end{bmatrix} = \begin{bmatrix} x(n) & x(n-1) & \dots & x(n-P+1) & d(n-1) & \dots & d(n-P_r+1) \\ x(n+K) & x(n+K-1) & \dots & x(n+K-P+1) & d(n+K-1) & \dots & d(n+K-P_r+1) \end{bmatrix} \text{G.31}$$

zum Einbringen der neuen Abtastwerte x(n+K), d(n+K-1) und zum Ausscheiden der ältesten Abtastwerte x(n - P + 1), d(n - $P_r$ + 1) im Verlauf der Bildung von $\underline{S}_E$ verwendet wird.

Schreibt man nämlich die erweiterte Datenmatrix (24) mit Zeilenvektorenwobei zu berücksichtigen ist, daß die Herleitung bisher Matrizen und Vektoren mit komplexen Komponenten umfaßte und im Gegensatz dazu nachfolgend nur reelle Daten vorausgesetzt werden. Komponenten von Vektoren werden in Form von Spalten (einspaltige Matrizen) angeordnet. Da sowohl Zeilen als auch Spalten von Matrizen als Vektoren aufgefaßt werden können, dienen zur Bezeichnung von Zeilenvektoren hochgestellte, für Spaltenvektoren tiefgestellte Indizes.

$$\underline{X}_E(n) = \begin{bmatrix} x(n) & x(n-1) & \dots & x(n-P+1) & d(n-1) & \dots & d(n-P_r+1) \\ x(n+1) & x(n) & \dots & x(n-P+2) & d(n) & \dots & d(n-P_r+2) \\ \dots & \dots & \dots & \dots & \dots & \dots & \dots \\ x(n+k) & x(n+k-1) & \dots & x(n+k-P+1) & d(n+k-1) & \dots & d(n+k-P_r+1) \\ \dots & \dots & \dots & \dots & \dots & \dots & \dots \\ x(n+K-1) & x(n+K-2) & \dots & x(n+K-P) & d(n+K-2) & \dots & d(n+K-P_r) \end{bmatrix} = \begin{bmatrix} \mathbf{x}_E^n \\ \mathbf{x}_E^{n+1} \\ \dots \\ \mathbf{x}_E^{n+k} \\ \dots \\ \mathbf{x}_E^{n+K-1} \end{bmatrix}$$

$$\text{G.32}$$

so läßt sich zeigen, daß für $\underline{R}_{sE} = \underline{X}_E^T \cdot \underline{K}^T \cdot \underline{K} \cdot \underline{X}_E$ die Beziehung

$$\underline{R}_{sE}(n+1) = \underline{R}_{sE}(n) - \begin{pmatrix} \mathbf{x}_{E_n} & -\mathbf{x}_{E_{n+K}} \end{pmatrix} \cdot \begin{pmatrix} \kappa(n)^2 & 0 \\ 0 & \kappa(n+K)^2 \end{pmatrix} \cdot \begin{pmatrix} \mathbf{x}_E^n \\ \mathbf{x}_E^{n+K} \end{pmatrix} \qquad \text{G.33}$$

und für $\mathbf{P}_{sE} = \underline{X}_E^T \cdot \underline{K}^T \cdot \underline{K} \cdot \mathbf{d}$ somit

$$\mathbf{P}_{sE}(n+1) = \mathbf{P}_{sE}(n) - \left(\mathbf{x}\,\mathbf{E}_n \quad -\mathbf{x}\,\mathbf{E}_{n+K}\right) \cdot \begin{pmatrix} \kappa(n)^2 & 0 \\ 0 & \kappa(n+K)^2 \end{pmatrix} \cdot \begin{pmatrix} d(n) \\ d(n+K) \end{pmatrix} \text{gilt.} \qquad \text{G.34}$$

Zur Lösung nach G.29 muß die Inverse von G.33 gebildet werden; dies ermöglicht die sogen. Identität von Identität von Frobenius/Schur/Woodbury (hier geschrieben mit den vier Matrizen $\underline{A}$, $\underline{B}$, $\underline{C}$ und $\underline{D}$)

$$(\underline{A} - \underline{B}\cdot\underline{D}\cdot\underline{C})^{-1} = \underline{A}^{-1} + \underline{A}^{-1}\cdot\underline{B}\cdot\underline{\Delta}^{-1}\cdot\underline{C}\cdot\underline{A}^{-1} \qquad \text{G.35a}$$

mit

$$\underline{\Delta} = \underline{D}^{-1} - \underline{C}\cdot\underline{A}^{-1}\cdot\underline{B} \qquad \text{G.35b}$$

regulär.
An sich darf man die drei Matrizen $\underline{B}$, $\underline{D}$ und $\underline{C}$ ganz beliebig wählen, wenn nur ihre Formate nach Fig. 3 zueinander passen:
Vergleicht man Gleichung G.33 und mit der Identität in der Gestalt G.35, so erkennt man, daß G.35 zur Bildung der Inversen von G.33 benutzt werden kann:
Mit der Abkürzung

$$\underline{Z}_{\underline{E}} = \underline{R}_{sE}(n)^{-1}\cdot\underline{C}_{\underline{E}}^T\cdot\begin{pmatrix} 1 & 0 \\ 0 & -1 \end{pmatrix} \qquad \text{G.36}$$

und der 2x2-Matrix $\underline{s}_E$ nach G.30 (entspricht $\underline{\Delta}$ in G.35b) folgt nämlich die rekursive Beziehung

$$\underline{R}_{sE}(n+1)^{-1} = \underline{R}_{sE}(n)^{-1} + \underline{Z}_{\underline{E}}\cdot\left[\underline{S}_{\underline{E}}^{-1}\begin{bmatrix} 1 & 0 \\ 0 & -1 \end{bmatrix}\right]\cdot\underline{Z}_{\underline{E}}^T \qquad \text{G.37}$$

und wegen

$$\begin{bmatrix} y_{AE}(n) \\ y_{AE}(n+K) \end{bmatrix} = \underline{C}_{\underline{E}}\cdot\underline{h}_{Eopt}(n) \qquad \text{G.38}$$

für den optimalen Koeffizientenvektor

$$\underline{h}_{Eopt}(n+1) = \underline{h}_{Eopt}(n) + \underline{Z}_{\underline{E}}\cdot\underline{S}_{\underline{E}}^{-1}\cdot\begin{bmatrix} y_{AE}(n) - d(n) \\ y_{AE}(n+K) - d(n+K) \end{bmatrix} \qquad \text{G.39}$$

Somit ist der optimale Koeffizientenvektor $\mathbf{h}_{Eopt}(n+1)$ nach G.39, bzw. G.25 bei n+1 gefunden, wobei auch bei beliebig großen Matrizen, nur die Inverse der 2x2-Matrix nach G.30 zu bilden notwendig ist, um Gleichung G.37 und schließlich Gleichung G.39 benutzen zu können.
Ein weiteres Merkmal der Erfindung ist dadurch gekennzeichnet, daß zur Initialisierung des rekursiven Verfahrens, die Bildung von Inverser $\underline{R}_{sE}(n_{start})^{-1}$ von $\mathbf{P}_{sE}(n_{start})$ und die Lösung $h_{Eopt}(n_{start})$ der "Wiener-Hopf" Gleichung zu speziell ausgewählten Eingangs - und Referenzsignalverläufen, welche dort an Stelle der entsprechenden Ausschnitte der Eingangs - und Referenzsignalverläufe der Nutzsignale treten, vorab für den Startzeitpunkt $n_{start}$ geschieht, und von denen ausgehend ein "Hineingleiten" bezüglich x(n) und d(n) in das oben beschriebene Verfahren so erfolgt, daß nach K Abtastwerten, dieser Vorspann völlig unwirksam für den weiteren Verlauf geworden ist.

**Patentansprüche**

1.  Verfahren zur Adaption der Koeffizienten eines digitalen Filters an die Koeffizienten der Systemfunktion

$$H(z) = \frac{A(z)}{1 - B(z)} = \frac{a_0 + a_1 \cdot z^{-1} + \ldots + a_{P-1} \cdot z^{-(P-1)}}{1 - \left[ b_1 \cdot z^{-1} + b_2 \cdot z^{-2} + \ldots + b_{P_r-1} \cdot z^{-(P_r-1)} \right]}$$

nach dem Equation-Error-Prinzip, **dadurch gekennzeichnet, daß** ein skalierter Fehler $\kappa(n) \cdot \varepsilon_E(n) = \kappa(n) \cdot d(n) - \kappa(n) \cdot y_E$ gebildet wird und die über n, n+1,..., N+K-1 erstreckte Summe der Quadrate solcher skalierter Fehler durch optimale Wahl der Elemente des Vektors $\mathbf{h}_E(n) = (h_A(0)\ h_A(1) \ldots h_A(P-1)\ h_B(1) \ldots h_B(P_r-1))$ minimisiert - somit $h_A(k) \approx a_k$, $h_B(k) \approx b_k$ nach $K + P + P_r$-Abtastwerten - wird und daß ausgehend von einem, zum Zeitpunkt n bekannten, optimalen Koeffizientensatz $\mathbf{h}_E(n)$, bekannter Inverser $\underline{R}_{sE}^{-1}$ und $\mathbf{P}_{sE}$, für den Zeitpunkt n+1, die Lösung $\mathbf{h}_E(n+1)$ der Wiener-Hopf"- Gleichung $\underline{R}_{sE} \cdot \mathbf{h}_E = \mathbf{P}_{sE}$ so rekursiv ermittelt wird, daß stets nur eine 2x2-Matrix

$$\underline{S}_E := \begin{pmatrix} \dfrac{1}{\kappa(n)^2} & 0 \\ 0 & \dfrac{1}{\kappa(n+K)^2} \end{pmatrix} - \underline{C}_E \cdot \underline{R}_{sE}^{-1} \cdot \underline{C}_E^T \cdot \begin{pmatrix} 1 & 0 \\ 0 & -1 \end{pmatrix}$$

im Verlauf der rekursiven Berechnung invertiert werden muß, wobei eine Informationsmatrix

$$\underline{C}_E = \begin{bmatrix} \mathbf{x}_E^n \\ \mathbf{x}_E^{n+K} \end{bmatrix} = \begin{bmatrix} x(n) & x(n-1) & \ldots & x(n-P+1) & d(n-1) & \ldots & d(n-P_r+1) \\ x(n+K) & x(n+K-1) & \ldots & x(n+K-P+1) & d(n+K-1) & \ldots & d(n+K-P_r+1) \end{bmatrix}$$

zum Einbringen der neuen Abtastwerte x(n+K), d(n+K-1) und zum Ausscheiden der ältesten Abtastwerte x(n - P + 1), d(n - $P_r$ + 1) im Verlauf der Bildung von $\underline{S}_E$ verwendet wird.

2.  Verfahren nach Anspruch 1, **dadurch gekennzeichnet, daß** zur Initialisierung des rekursiven Verfahrens, die Bildung von Inverser $\underline{R}_{sE}^{-1}$, von $\mathbf{P}_{sE}$ und die Lösung $\mathbf{h}_E$ der "Wiener-Hopf" Gleichung zu speziell ausgewählten Eingangs - und Referenzsignalverläufen, welche dort an Stelle der entsprechenden Ausschnitte der Eingangs - und Referenzsignalverläufe der Nutzsignale treten, vorab geschieht, und von denen ausgehend ein "Hineingleiten" bezüglich x(n) und d(n) in das Verfahren nach Anspruch 1 so erfolgt, daß nach K Abtastwerten, dieser Vorspann völlig unwirksam für den weiteren Verlauf geworden ist.

Fig. 1

Fig. 2

Fig. 3